# EUROPEAN PATENT APPLICATION

(11) **EP 4 455 224 A1**
(43) Date of publication of application: **30.10.2024**
(21) Application number: 22911329.5
(22) Date of filing: 22.12.2022
(51) Int. Cl.: C08L 83/04, B32B 15/08, B32B 27/00, C08G 73/10, C08G 77/14, C08L 79/08

(54) **CURABLE RESIN COMPOSITION, CURED FILM, LAMINATE, IMAGING DEVICE, SEMICONDUCTOR DEVICE, METHOD FOR MANUFACTURING LAMINATE, AND METHOD FOR MANUFACTURING ELEMENT HAVING CONTACT ELECTRODE**

(30) Priority: 23.12.2021 JP 2021209413; 23.12.2021 JP 2021209414
(71) Applicant: SEKISUI CHEMICAL CO., LTD., Osaka-shi, Osaka 530-0047 (JP)
(72) Inventor: NOMOTO, Hayate, Mishima-gun, Osaka 618-0021 (JP); SHIOJIMA, Taro, Mishima-gun, Osaka 618-0021 (JP); SHICHIRI, Tokushige, Mishima-gun, Osaka 618-0021 (JP); SATO, Kenichiro, Mishima-gun, Osaka 618-0021 (JP); DEGUCHI, Hidenobu, Mishima-gun, Osaka 618-0021 (JP)
(74) Representative: Cabinet Beau de Loménie
(86) International application number: PCT/JP2022/047305
(87) International publication number: WO 2023/120627

(57) **Abstract**

The present invention aims to provide a curable resin composition capable of forming a film which, even when made thick, is less likely to crack at high temperature under a nitrogen atmosphere, a cured film formed using the curable resin composition, a stack including the cured film, an imaging device including the stack, an semiconductor device including the stack, a method for producing the stack, and a method for producing an element including a bonding electrode for use in production of the stack. Provided is a curable resin composition containing: a polyimide; and a silsesquioxane, the polyimide being contained in an amount of 0.5 parts by weight or more and 50 parts by weight or less relative to 100 parts by weight of the silsesquioxane.

## Description

### TECHNICAL FIELD

The present invention relates to a curable resin composition, a cured film formed using the curable resin composition, a stack including the cured film, an imaging device including the stack, a semiconductor device including the stack, a method for producing the stack, and a method for producing an element including a bonding electrode for use in production of the stack.

### BACKGROUND ART

With higher performance of semiconductor devices, 3D stacking of multiple semiconductor chips has been developed. The production of such a stack of multiple semiconductor chips first includes the formation of a bonding surface, which includes copper-made bonding electrodes surrounded by an insulating film, by the damascene process on each of the electrode surfaces of two elements provided with the electrodes. The two elements are then stacked on top of each other such that the bonding electrodes of the bonding surfaces face each other, and then heat-treated to produce a stack (Patent Literature 1).

### CITATION LIST

### - Patent Literature

Patent Literature 1: JP 2006-191081 A

### SUMMARY OF INVENTION

### - Technical problem

In the production of the stack, bonding of the electrodes involves high-temperature treatment at 400°C for four hours. The insulating layers used to form the bonding surfaces thus require high heat resistance. Conventional stacks therefore use insulating inorganic materials such as Si₃N₄ and SiO₂ as the insulating layers. However, insulating layers made of inorganic materials tend to cause warping of the elements. A warped element may cause misalignment of the electrode connecting positions or cracking of electrodes in the stack to be obtained. This may reduce the connection reliability of the stack. As the recent semiconductor devices have higher performance, elements have become larger and thinner, and thus become more susceptible to warping.

One possible way to reduce such warping of elements is to use insulating layers made of organic compounds. However, insulating layers made of organic compounds are sensitive to heat. To address this, heat-resistant organic compounds may be used. However, producing insulating layers requires forming films with a certain thickness. Thick films of conventional heat-resistant organic compounds may not withstand high-temperature treatment under a nitrogen atmosphere at 400°C for four hours, leading to film cracking.

The present invention aims to provide a curable resin composition capable of forming a film which, even when made thick, is less likely to crack at high temperature under a nitrogen atmosphere, a cured film formed using the curable resin composition, a stack including the cured film, an imaging device including the stack, an semiconductor device including the stack, a method for producing the stack, and a method for producing an element including a bonding electrode for use in production of the stack.

### - Solution to problem

The present invention encompasses the following disclosures. The present invention is described in detail below.

### [Disclosure 1]

A curable resin composition containing: a polyimide; and a silsesquioxane, the polyimide being contained in an amount of 0.5 parts by weight or more and 50 parts by weight or less relative to 100 parts by weight of the silsesquioxane.

### [Disclosure 2]

The curable resin composition according to the disclosure 1, wherein the polyimide has a siloxane bond.

### [Disclosure 3]

The curable resin composition according to the disclosure 2, wherein the polyimide has a ratio of carbon atoms to silicon atoms, C/Si, of 17 or less in a main chain structure.

### [Disclosure 4]

The curable resin composition according to any one of the disclosures 1 to 3, wherein the polyimide has a weight average molecular weight of 1,000 or greater and 20,000 or less.

### [Disclosure 5]

The curable resin composition according to any one of the disclosures 1 to 4, wherein the polyimide has an oxazine ring or imide ring structure at at least one terminal.

### [Disclosure 6]

The curable resin composition according to any one of the disclosures 1 to 5, wherein at least one terminal of the polyimide has a structure represented by any of the following formulas (1) to (6):

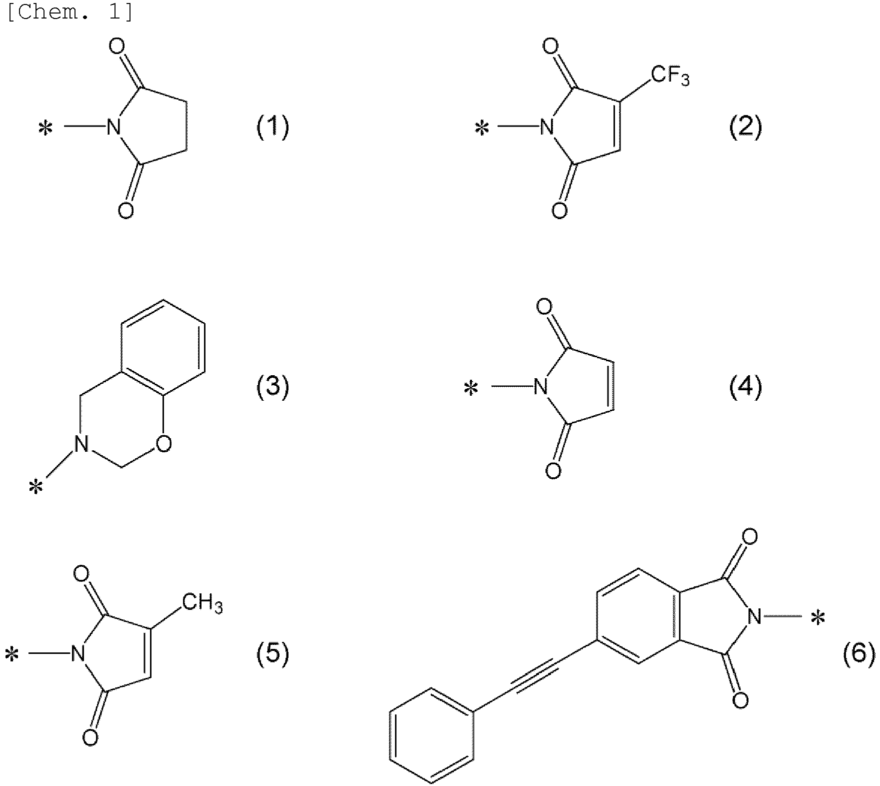

### [Disclosure 7]

The curable resin composition according to any one of the disclosures 1 to 6, wherein the silsesquioxane has a structure represented by the following formula (7): 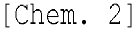 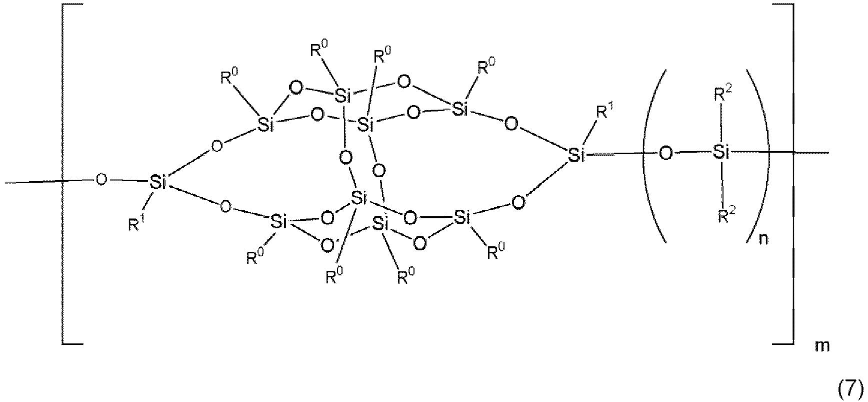 wherein R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

### [Disclosure 8]

A cured film formed using the curable resin composition according to any one of the disclosures 1 to 7.

### [Disclosure 9]

A stack including: a first element including an electrode; a second element including an electrode; and the cured film according to the disclosure 8 between the first element and the second element,
the electrode of the first element and the electrode of the second element being electrically connected to each other via a through-hole extending through the cured film.

### [Disclosure 10]

The stack according to the disclosure 9, including an inorganic layer between the first element and second element.

### [Disclosure 11]

The stack according to the disclosure 9 or 10, including a barrier metal layer on a surface of the through-hole.

### [Disclosure 12]

An imaging device including the stack according to any one of the disclosures 9 to 11.

### [Disclosure 13]

A semiconductor device including the stack according to any one of the disclosures 9 to 11.

### [Disclosure 14]

A method for producing a stack, including the steps of: forming cured films by forming a film of the curable resin composition according to any one of the disclosures 1 to 7 on a surface of a first element including an electrode, the surface being a surface on which the electrode is formed, and a film of the curable resin composition on a surface of a second element including an electrode, the surface being a surface on which the electrode is formed, evaporating the solvent, and then curing the films; forming a through-hole in each of the cured films; filling the through-hole with a conductive material; forming bonding electrodes by polishing the surface of the first element on the side where the through-hole is filled with the conductive material and the surface of the second element on the side where the through-hole is filled with the conductive material; and bonding the first element on which the bonding electrode is formed and a second element on which the bonding electrode is formed such that the bonding electrodes are bonded to each other.

### [Disclosure 15]

A method for producing an element including a bonding electrode, including the steps of: forming a cured film by forming a film of the curable resin composition according to any one of the disclosures 1 to 7 on a surface of a first element including an electrode, the surface being a surface on which the electrode is formed, evaporating the solvent, and then curing the film; forming a through-hole in the cured film; filling the through-hole with a conductive material; and forming a bonding electrode by polishing the surface of the element.

### [Disclosure 16]

A stack including: a supporting substrate; a third element; and the cured film according to the disclosure 8 or 9 between the supporting substrate and the third element, the third element having a first surface and a second surface and including a plurality of chips stacked on the first surface, the chips being electrically connected to the third element, the cured film being provided between the first surface and the supporting substrate.

### [Disclosure 17]

The stack according to the disclosure 16, including an inorganic layer between the supporting substrate and the cured film.

### [Disclosure 18]

The stack according to the disclosure 16 or 17, further including a fourth element on the second surface of the third element, wherein the third element and the fourth element are electrically connected to each other.

### [Disclosure 19]

An imaging device including the stack according to any one of the disclosures 16 to 18.

### [Disclosure 20]

A semiconductor device including the stack according to any one of the disclosures 16 to 18.

The curable resin composition of the present invention contains a polyimide.

When a polyimide is used in the curable resin composition, even a thick cured film of the composition is less likely to crack in high-temperature treatment.

The polyimide preferably has a siloxane bond.

When the polyimide has a siloxane bond, the compatibility of the polyimide with the silsesquioxane contained in the curable resin composition is enhanced, so that irregularities (surface roughening) due to precipitation of the polyimide in application can be reduced.

When the polyimide has a siloxane bond, the polyimide preferably has a ratio of carbon atoms to silicon atoms, C/Si, of 17 or less in a main chain structure.

When the ratio of carbon atoms to silicon atoms in the main chain of the polyimide is within the range, the compatibility of the polyimide with the silsesquioxane contained in the curable resin composition is further enhanced, so that surface roughening in application can be further reduced. The C/Si is more preferably 16.5 or less, still more preferably 16 or less. The lower limit of the C/Si is not limited, but is preferably 4 or greater, from the standpoint of practical use and further enhancing the heat resistance at 400°C.

Here, the ratio of carbon atoms to silicon atoms, C/Si, in the main chain structure of the polyimide is the ratio of C to Si in the repeating units and excludes C and Si at both terminals. The C/Si can be determined by obtaining the structure of the polyimide by ¹H-NMR, ¹³C-NMR, and ²⁹Si-NMR and measuring the number of C atoms and Si atoms from the repeating units of the main chain.

When importance is placed on reducing film cracking due to high temperature under an oxygen atmosphere, the polyimide also preferably has no siloxane bond or has a ratio of carbon atoms to silicon atoms, C/Si, of 20 or greater in the main chain structure.

When the polyimide has no siloxane bond or has a ratio of carbon atoms to silicon atoms in the above range in the main chain structure, the resulting cured film is less likely to crack even if a stack needs to be produced under an oxygen atmosphere, which is severer than a nitrogen atmosphere, due to restrictions in terms of equipment or production methods. The C/Si is more preferably 21 or greater. Here, since a stack is typically produced by bonding elements under a nitrogen atmosphere, a stack can exhibit sufficient connection reliability if the insulating layers do not crack at high temperature under a nitrogen atmosphere.

The polyimide preferably has a plurality of aromatic rings.

When the polyimide has a plurality of aromatic rings, even a thick cured film of the curable resin composition is less likely to crack in high-temperature treatment under various conditions.

The polyimide preferably has an oxazine ring or imide ring structure at at least one terminal, more preferably both terminals.

The polyimide having an oxazine ring or imide ring structure at a terminal can further reduce surface roughening when a thick film is formed. The oxazine ring structure and the imide ring structure may have a substituent.

The polyimide still more preferably has a structure of any of the formulas (1) to (6) at at least one terminal, particularly preferably both terminals. Here, "*" in the formulas represents a linking site to a portion other than the terminal of the polyimide.

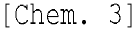

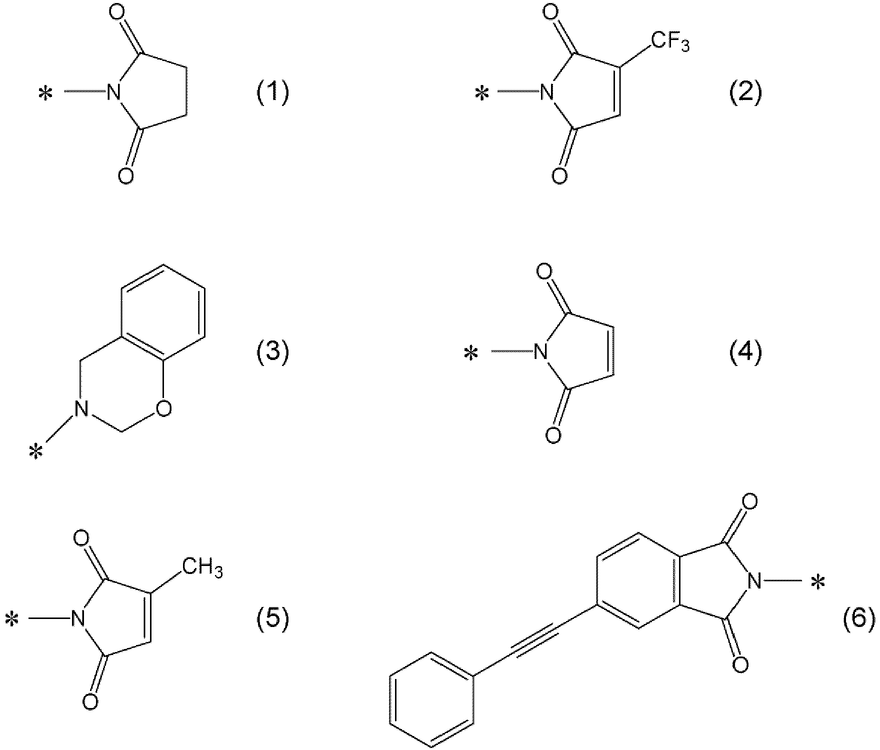

The polyimide preferably has a weight average molecular weight of 1,000 or greater and 20,000 or less.

When the weight average molecular weight of the polyimide is within the range, the compatibility of the polyimide with the silsesquioxane can be improved, leading to higher handleability. The weight average molecular weight is more preferably 2,000 or greater, still more preferably 3,000 or greater and is more preferably 18,000 or less, still more preferably 15,000 or less.

The weight average molecular weight of the polyimide is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The amount of the polyimide is 0.5 parts by weight or more and 50 parts by weight or less relative to 100 parts by weight of the later-described silsesquioxane.

When the amount of the polyimide is within the range, even a thick cured film of the composition is less likely to crack in high-temperature treatment. The amount of the polyimide is preferably 0.7 parts by weight or more, more preferably 0.75 parts by weight or more, still more preferably 1 part by weight or more and is preferably 20 parts by weight or less, more preferably 10 parts by weight or less, still more preferably 5 parts by weight or less, relative to 100 parts by weight of the silsesquioxane.

The curable resin composition of the present invention contains a silsesquioxane.

Using a cured film of the organic curable resin composition as an insulating layer can increase the flexibility, which can reduce warping of elements and enhance the electrical connection reliability. Moreover, using a silsesquioxane in the curable resin composition allows the insulating layer to have excellent heat resistance.

The silsesquioxane preferably has a structure represented by the following formula (7). When the silsesquioxane has a structure of the formula (7), the heat resistance can be further enhanced, while misalignment or cracking of electrodes can be further reduced to enhance the electrical connection reliability.

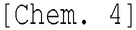

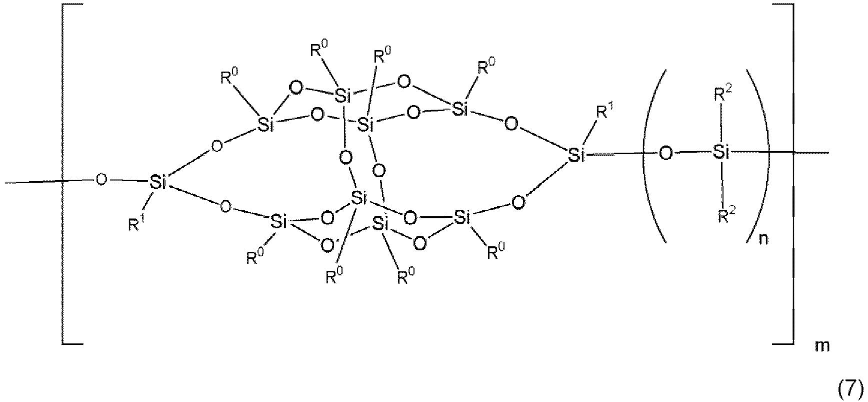

In the formula, R⁰s, R¹s, and R²s each independently represent a linear, branched, or cyclic aliphatic group, an aromatic group, or hydrogen; the aliphatic group and the aromatic group optionally have a substituent; and m and n each represent an integer of 1 or greater.

In the formula (7), R⁰s each independently represent a linear, branched, or cyclic aliphatic group, an aromatic group, or hydrogen; the aliphatic group and the aromatic group optionally have a substituent; and R⁰s are each preferably a phenyl group, a C1-C20 alkyl group, or an arylalkyl group, more preferably a phenyl group. When R⁰s are each a phenyl group, a C1-C20 alkyl group, or an arylalkyl group, the silsesquioxane can have higher heat resistance.

In the formula (1), R¹s and R²s each independently represent a linear, branched, or cyclic aliphatic group, an aromatic group, or hydrogen; the aliphatic group and the aromatic group optionally have a substituent; and R¹s and R²s are each preferably a phenyl group, a C1-C20 alkyl group, or an arylalkyl group, more preferably a phenyl group or a methyl group. When R¹s and R²s are each a phenyl group, a C1-C20 alkyl group, or an arylalkyl group, the silsesquioxane can have higher heat resistance.

In the formula (1), m and n are each an integer of 1 or greater and represent the number of repeating units; m is preferably 30 or greater, more preferably 50 or greater and is preferably 100 or less; and n is preferably 1 or greater, more preferably 3 or greater and is preferably 8 or less, more preferably 6 or less.

The silsesquioxane preferably has a reactive site.

Using a reactive site-containing silsesquioxane as the curable resin of the curable resin composition can further reduce cracking of the cured film of the curable resin composition even in heating treatment at 400°C. Moreover, silsesquioxanes have excellent heat resistance, so that they can further reduce decomposition of the cured film due to high-temperature treatment performed in the production of the stack or an electronic component including the stack. Examples of the reactive site include a hydroxy group and an alkoxy group. Examples of the reactive site-containing silsesquioxane include silsesquioxanes represented by the formula (7). Although not shown in the structural formula, silsesquioxanes represented by the formula (7) have, at both terminals thereof, reactive functional groups derived from raw materials.

The amount of the silsesquioxane in 100 parts by weight of the amount of solids in the curable resin composition is preferably 85 parts by weight or more, more preferably 90 parts by weight or more, still more preferably 95 parts by weight or more. The amount of the silsesquioxane in 100 parts by weight of the amount of solids in the curable resin composition is preferably 99 parts by weight or less, more preferably 98 parts by weight or less.

The silsesquioxane may have any weight average molecular weight and preferably has a weight average molecular weight of 5,000 or greater and 150,000 or less. When the molecular weight of the silsesquioxane is within the range, the film-forming properties in application can be increased to further enhance the planarization properties. Moreover, misalignment or cracking of electrodes can be further reduced. The molecular weight of the silsesquioxane is more preferably 10,000 or greater, still more preferably 30,000 or greater and is more preferably 100,000 or less, still more preferably 70,000 or less.

The weight average molecular weight of the silsesquioxane is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The silsesquioxane having a structure of the formula (7) can be obtained by, for example, reacting a compound (8) represented by the following formula (8) with a compound (9) represented by the following formula (9).

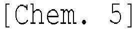

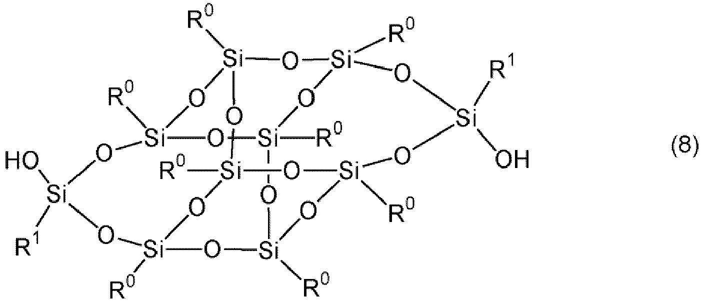

In the formula (8), R⁰s and R¹s represent the same functional groups as R⁰s and R¹s in the formula (7).

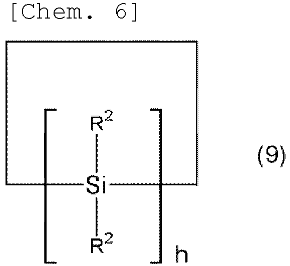

In the formula (9), R²s represent the same functional groups as R²s in the formula (7). In the formula (9), h represents a natural number, preferably 3 to 6, more preferably 3 or 4.

The compound having a structure of the formula (7) can also be obtained by reacting the compound (8) with a halogenated siloxane having R² (e.g., dimethyl siloxane having a chlorinated terminal) instead of the compound (9).

The compound (8) can be obtained by, for example, reacting a salt such as a compound (10) represented by the following formula (10) with a compound (11) represented by the following formula (11). The compound (8) can also be obtained by reacting the compound (11) wherein X is hydrogen with the compound (10) followed by hydrolysis.

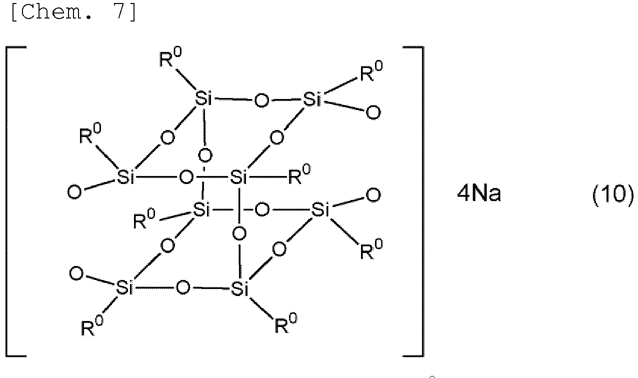

In the formula (10), R⁰s represent the same functional groups as R⁰s in the formula (7).

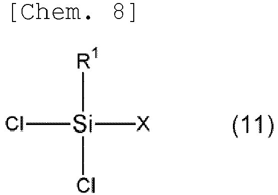

In the formula (11), R¹ represents the same functional group as R¹s in the formula (7); and X represents hydrogen, chlorine, or a hydroxy group.

The compound (10) can be produced by, for example, hydrolysis and polycondensation of a compound (12) represented by the following formula (12) in the presence of a monovalent alkali metal hydroxide and water and in the presence or absence of an organic solvent. The monovalent alkali metal hydroxide used may be lithium hydroxide, sodium hydroxide, potassium hydroxide, cesium hydroxide, or the like.

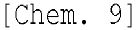

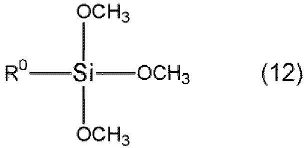

In the formula (12), R⁰ represents the same functional group as R⁰s in the formula (7).

The curable resin composition of the present invention preferably contains a catalyst that promotes curing reaction.

When the curable resin composition contains a catalyst, the curable resin composition can be more completely cured, which can further reduce the decomposition of the cured film due to high-temperature treatment.

Examples of the catalyst include: organotin compounds such as dibutyltin dilaurate and tin(II) acetate; metal carboxylates such as zinc naphthenate; zirconia compounds such as zirconium tetraacetylacetonate; and titanium compounds. Preferred among these are zirconium tetraacetylacetonate because it can further reduce pyrolysis of the cured film obtained by curing the curable resin composition.

The catalyst remains after the curable resin composition is cured. In other words, the cured film obtained by curing the curable resin composition of the present invention preferably contains a catalyst that promotes curing reaction.

The amount of the catalyst is not limited and is preferably 0.01 parts by weight or more and 10 parts by weight or less relative to 100 parts by weight of the silsesquioxane in the curable resin composition. When the amount of the catalyst is within the range, curing of the curable resin composition can be further promoted. The amount of the catalyst is more preferably 0.1 parts by weight or more, still more preferably 0.2 part by weight or more and is more preferably 7 parts by weight or less, still more preferably 5 parts by weight or less.

The curable resin composition preferably contains a polyfunctional crosslinking agent capable of reacting with a reactive site of the reactive site-containing silsesquioxane.

Crosslinking between the polymer chains of the reactive site-containing silsesquioxane by a polyfunctional crosslinking agent capable of reacting with a reactive site of the silsesquioxane increases the crosslinking density of the cured product, thus further reducing decomposition at high temperature. As a result, the generation of voids due to the generation of decomposed gas during high-temperature treatment, as well as the resulting misalignment of electrodes in bonding and reduction in electrical connection reliability, can be further prevented. Examples of the polyfunctional crosslinking agent in the case where the reactive site is a silanol group include alkoxysilane compounds such as dimethoxysilane compounds, trimethoxysilane compounds, diethoxysilane compounds, and triethoxysilane compounds and silicate oligomers obtained by condensation of a tetramethoxysilane compound and a tetraethoxysilane compound. In particular, for improvement in the crosslinking density and heat resistance, silicate oligomers are preferred. Examples of alkoxysilane compounds include dimethoxydimethylsilane, trimethoxymethylsilane, tetraethoxysilane, tetrapropoxysilane, and tetrabutoxysilane. Examples of silicate oligomers include Silicate MS51, Silicate MS56, Silicate MS57, and Silicate MS56S (all available from Mitsubishi Chemical Corporation) and Ethyl Silicate 40, Ethyl Silicate 48, and EMS 485 (all available from Colcoat Co., Ltd.).

The amount of the polyfunctional crosslinking agent is not limited but is preferably 1 part by weight or more and 50 parts by weight or less relative to 100 parts by weight of the curable resin in the curable resin composition. When the amount of the polyfunctional crosslinking agent is within the range, the cured film can have a crosslinking density within a suitable range and also can have a hardness within the above-described range after heat treatment. The amount of the polyfunctional crosslinking agent is more preferably 3 parts by weight or more, still more preferably 3.2 parts by weight or more and is more preferably 30 parts by weight or less, still more preferably 20 parts by weight or less.

The curable resin composition may contain other additives such as viscosity modifiers, fillers, adhesion-imparting agents, and solvents as necessary.

The curable resin composition of the present invention may be used in any application. Since even a thick cured film of the curable resin composition is less likely to crack due to high temperature under a nitrogen atmosphere, the curable resin composition can be suitably used as an insulating layer in the production of a stack by electrically connecting electrodes of two elements including electrodes.

The present invention also encompasses such a cured film formed using the curable resin composition of the present invention.

The present invention also encompasses a stack including a first element including an electrode, a second element including an electrode, and the cured film of the present invention between the first element and the second element, the electrode of the first element and the electrode of the second element being electrically connected to each other via a through-hole extending through the cured film (hereinafter the stack is also simply referred to as a stack or a stack A). The stack of the present invention is described below.

The stack of the present invention includes a first element including an electrode, a second element including an electrode, and the cured film of the present invention between the first element and the second element, the electrode of the first element and the electrode of the second element being electrically connected to each other via a through-hole extending through the cured film.

The cured film provided between the electrode of the first element (hereinafter also referred to as a first electrode) and the electrode of the second element (hereinafter also referred to as a second electrode) serves as an insulating layer to reduce short-circuit current. Conventional insulating layers contain hard inorganic materials such as Si₃N₄ and SiO₂, and thus cannot eliminate warping by stress relaxation when warping occurs in the formation of an insulating layer or in the formation of a stack. As a result, warping of elements and misalignment or cracking of electrodes due to the warping are likely to occur. In the present invention, the cured film more flexible than an inorganic material film is used as the insulating layer, thus allowing the stack to exhibit high electrical connection reliability. In particular, the cured film of the present invention is less likely to crack even when made thick, thus allowing the stack to have higher electrical connection reliability. Moreover, conventional insulating layers take time to produce because they are formed by vapor deposition. However, the cured film of the stack of the present invention can be formed by, for example, applying and curing the curable resin composition, thus increasing production efficiency.

The "electrically connected" as used herein means a state in which the first electrode and the second electrode are connected to each other via a conductive material or the like filling the through-hole.

The first element and the second element are not limited and each may be a circuit element provided with an element, a wire, and an electrode. For example, the first element and the second element each may be a sensor circuit element provided with a pixel portion (pixel region) or a circuit element mounted with a peripheral circuit portion such as a logic circuit that implements various types of signal processing related to the operation of a solid-state imaging device, for example.

The materials of the electrodes of the first element and the second element and the conductive material are not limited. Conventional electrode materials such as gold, copper, and aluminum may be used.

The cured film may have any thickness and preferably has a thickness of 10 um or greater and 300 um or less.

When the thickness of the cured film is within the range, the cured film can further exhibit the function as an insulating layer while further reducing misalignment or cracking of electrodes. The thickness of the cured film is more preferably 20 um or greater, still more preferably 30 um or greater and is more preferably 200 um or less, still more preferably 100 um or less.

The stack of the present invention preferably includes an inorganic layer between the first element and the second element.

Providing an inorganic layer between the first element and the second element increases insulation, resulting in a stack having better connection reliability. Conventional stacks include an insulating layer made of an inorganic material having a thickness of about 10 to 20 um, and thus cannot eliminate warping of the elements and the stack, leading to reduced connection reliability. In the stack of present invention, the insulating layer is the cured film, and thus when the inorganic layer is thin, the stack of the present invention can eliminate warping of the elements and the stack while exhibiting the effect of the inorganic layer.

The material of the inorganic layer is not limited. Examples thereof include Si₃N₄, SiO₂, and Al₂O₃. Preferred among these are Si₃N₄ and SiO₂ because they have excellent insulation and heat resistance.

To further increase the connection reliability of the stack, the inorganic layer preferably has a thickness of 1 nm or greater, more preferably 5 nm or greater, still more preferably 10 nm or greater, while preferably 1 um or less, more preferably 500 nm or less, still more preferably 100 nm or less.

The stack of the present invention preferably includes a barrier metal layer on a surface of the through-hole.

The barrier metal layer serves to prevent the conductive material (e.g., Cu atoms in the case of Cu electrode) filling the through-hole from diffusing into the cured film. The barrier metal layer provided on the surface of the through-hole covers the conductive material filling the through-hole except for the surfaces that contact the electrodes. This can further reduce short circuiting and conduction failure caused by the diffusion of the conductive material into the cured film. The material of the barrier metal layer may be a known material such as tantalum, tantalum nitride, titanium nitride, silicon oxide, or silicon nitride.

The barrier metal layer may have any thickness. To further increase the connection reliability of the stack, the barrier metal layer more preferably has a thickness of 1 nm or greater, still more preferably 10 nm or greater, while more preferably 100 nm or less, still more preferably 50 nm or less.

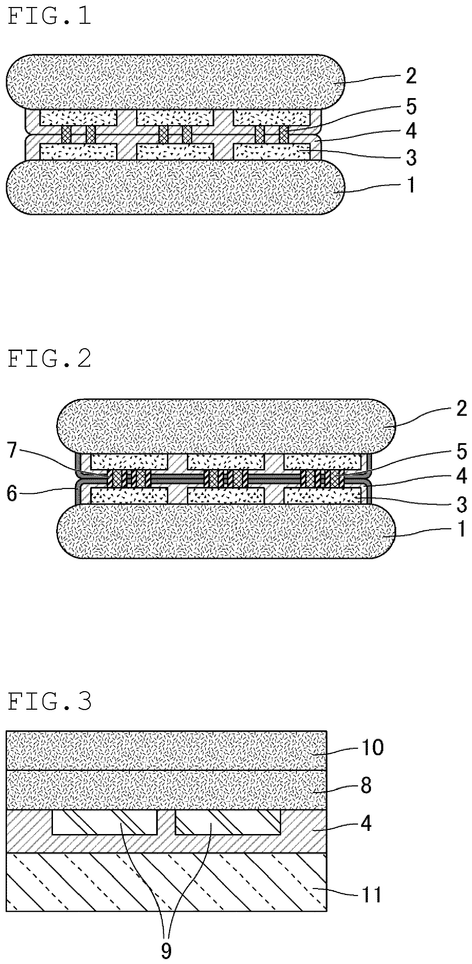

FIG. 1 is a schematic view of an embodiment of the stack of the present invention. As shown in FIG. 1, in the stack of the present invention, a first element 1 including electrodes 3 and a second element 2 including electrodes 3 are bonded to each other through cured films 4. The electrodes 3 on the first element 1 and the electrodes 3 on the second element 2 are electrically connected to each other via a conductive material filling through-holes 5 formed in the cured films 4. Conventional stacks include a hard inorganic material in place of the cured films 4, as an insulating layer. Conventional stacks thus cannot eliminate warping of the elements or the stack by stress relaxation and are more likely to have misalignment or cracking of electrodes. The present invention, which uses a flexible organic compound in the insulating layer, can eliminate warping of the elements and the stack and thus reduce misalignment or cracking of electrodes.

FIG. 2 is a schematic view of an embodiment of the stack of the present invention. In the embodiment in FIG. 2, inorganic layers 6 are formed between the cured films 4, providing higher insulation. The inorganic layers 6 may be far thinner than insulating layers of conventional stacks, and thus do not hinder the elimination of warping of the elements or the stack. Although in FIG. 2 the inorganic layers 6 are formed between the cured films 4, they may be formed on the first element 1 and the second element 2. Although in FIG. 2 the inorganic layers 6 are formed on the respective cured films 4 on the first element 1 side and the second element 2 side, an inorganic layer 6 may be formed on only one of the cured films 4. In the embodiment in FIG. 2, barrier metal layers 7 are formed on the surfaces of the through-holes 5. Forming barrier metal layers 7 on the surfaces of the through-holes 5 makes it difficult for the conductive material filling the through-holes 5 to diffuse into the cured films 4, and thus can further reduce short circuiting and conduction failure.

Examples of the method for producing the stack of the present invention include a method of producing a stack, including the steps of: forming cured films by forming a film of the curable resin composition of the present invention on a surface of a first element including an electrode, the surface being a surface on which the electrode is formed, and a film of the curable resin composition on a surface of a second element including an electrode, the surface being a surface on which the electrode is formed, evaporating the solvent, and then curing the films; forming a through-hole in each of the cured films; filling each of the through-holes with a conductive material; forming bonding electrodes by polishing the surface of the first element on the side where the through-hole is filled with the conductive material and the surface of the second element on the side where the through-hole is filled with the conductive material; and bonding the first element on which the bonding electrode is formed and the second element on which the bonding electrode is formed such that the bonding electrodes are bonded to each other. The present invention also encompasses such a method for producing a stack.

With the method for producing a stack of the present invention, first, the following step is performed: the step of forming a cured film by forming a film of the curable resin composition of the present invention on a surface of a first element including an electrode, the surface being a surface on which the electrode is formed, evaporating the solvent, and then curing the film.

The first element including an electrode, the second element including an electrode, and the curable resin composition may be the same as the first element including an electrode and the second element including an electrode in the stack of the present invention and the curable resin composition of the present invention. The cured film of the present invention is less likely to crack even when made thick, and thus can enhance the electrical connection reliability.

The method for forming the film is not limited. A conventionally known method such as a spin coating method may be used.

The conditions for evaporating the solvent are not limited. To reduce residual solvent and improve the heat resistance of the cured films, heating is preferably performed at a temperature of preferably 70°C or higher, more preferably 100°C or higher and preferably 250°C or lower, more preferably 200°C or lower for, for example, about 10 minutes, preferably about 15 minutes, more preferably about 30 minutes, still more preferably about one hour.

The curing conditions are not limited. To allow the curing reaction to sufficiently proceed and to further improve heat resistance, heating is preferably performed at a temperature of preferably 200°C or higher, more preferably 220°C or higher and preferably 400°C or lower, more preferably 300°C or lower for, for example, about 30 minutes or longer, preferably about one hour or longer, more preferably about two hours or longer. The upper limit of the heating time is not limited and is preferably three hours or shorter to reduce pyrolysis of the cured films.

With the method for producing a stack of the present invention, subsequently, the step of forming a through-hole in the cured film is performed.

The through-hole may be patterned. The method for forming the through-hole is not limited. The through-hole can be formed by laser irradiation such as CO₂ laser irradiation or etching. When a different layer is formed on an electrode surface of an element, the through-hole is formed to extend through the different layer as well as the cured film so that the electrode surface of the element is exposed.

With the method for producing a stack of the present invention, the step of forming an inorganic layer and/or a barrier metal layer is performed, as necessary.

The inorganic layer and the barrier metal layer may be the same as those in the stack of the present invention. The inorganic layer and the barrier metal layer can be formed by sputtering or vapor deposition, for example.

The step of forming an inorganic layer is preferably performed before and/or after the step of forming the cured films. The barrier metal layer is preferably formed after the step of forming a through-hole.

With the method for producing a stack of the present invention, subsequently, the step of filling the through-hole with a conductive material is performed. The method of filling the through-hole with the conductive material may be plating, for example.

The conductive material may be the same as the conductive material in the stack of the present invention.

With the method for producing a stack of the present invention, subsequently, the step of forming a bonding electrode by polishing the surface of the first element on the side where the through-hole is filled with the conductive material is performed.

Removing the conductive material on undesired portions by polishing forms a bonding electrode that connects the electrodes formed on the two elements. The polishing preferably planarizes and removes the layer formed of the conductive material until the cured film is exposed or until the inorganic layer, when it is present, is exposed.

The method for polishing is not limited and may be a chemical mechanical polishing method, for example.

The present invention also encompasses a method for producing an element including a bonding electrode, including the steps of: forming a cured film by forming a film of the curable resin composition of the present invention on a surface of an element including an electrode, the surface being a surface on which the electrode is formed, evaporating the solvent, and then curing the film; forming a through-hole in the cured film; filling the through-hole with a conductive material; forming a bonding electrode by polishing the surface of the element.

The element including a bonding electrode is a component used for forming a stack by bonding it to another element including a bonding electrode such that the bonding electrodes between the elements are bonded to each other. The descriptions for the element, the cured film, the curable resin composition, and other structures and the steps are the same as the descriptions for those in the curable resin composition, the stack, and the method for producing a stack of the present invention.

With the method for producing a stack of the present invention, subsequently, the following step is performed: the step of bonding the first element on which the bonding electrode is formed and a second element on which the bonding electrode is formed such that the bonding electrodes are bonded to each other.

The first element and the second element may be bonded by a method of connecting the electrodes and the bonding electrodes by melting them by heat treatment. The heat treatment is typically performed at about 400°C for about four hours.

The stack of the present invention may be used in any application. Since the stack has high electrical connection reliability and can particularly reduce warping or cracking of the elements or the stack even when thin elements are bonded to each other, the stack can be suitably used as a stack that constitutes a semiconductor device or an imaging device.

The present invention also encompasses such a semiconductor device including the stack of the present invention and such an imaging device including the stack of the present invention.

Examples of a stack including the cured film of the present invention other than the stack A include a stack in which a plurality of chips are stacked on an element, the chips being electrically connected to the element, and the surface of the element on which the chips are stacked is bonded to a supporting substrate via the cured film of the present invention. In a stack with such a structure, the cured film of the present invention does not directly protect the paths of electrical connection because there is no electrical connection between the supporting substrate and the element or between the supporting element and each chip. However, since the cured film of the present invention is less likely to crack at high temperature even when made thick, the cured film can reduce warping or cracking of the element and chips, and thus can enhance the electrical connection reliability between the element and each chip.

The present invention also encompasses such a stack. Specifically, the present invention also encompasses a stack including a supporting substrate, a third element, and the cured film of the present invention between the supporting substrate and the third element, the third element having a first surface and a second surface and including a plurality of chips stacked on the first surface, the chips being electrically connected to the third element, the cured film being provided between the first surface and the supporting substrate (hereinafter the stack is referred to as a stack B).

The stack B of the present invention includes a supporting substrate. Examples of the supporting substrate include glass and monocrystalline silicon.

The stack B of the present invention includes a third element having a first surface and a second surface. The third element includes a plurality of chips stacked on the first surface, the chips being electrically connected to the third element.

The third element may be the same element as the first element and the second element. Examples of the chips include memory circuit elements and logic circuit elements. These chips may be of a single type or may be a combination of chips of different types.
The "electrically connected" has the same meaning as in the stack A.

The stack B of the present invention preferably includes an inorganic layer between the supporting substrate and the cured film.

Further providing an inorganic layer between the supporting substrate and the cured film can further enhance insulation. The inorganic layer may be the same as the inorganic layer in the stack A of the present invention.

Preferably, the stack B of the present invention further includes a fourth element on the second surface of the third element, and the third element and the fourth element are electrically connected to each other.

The fourth element may be the same as the first to third elements.

FIG. 3 is a schematic view of an embodiment of the stack B of the present invention. As shown in FIG. 3, the stack B of the present invention includes a plurality of chips 9 stacked on a first surface of a third element 8, the chips being electrically connected to the third element 8. The stack B includes a fourth element 10 stacked on a second surface opposite to the first surface, the fourth element 10 being electrically connected to the third element 8. The first surface of the third element 8 and a supporting substrate 11 are stacked via a cured film 4. Conventional stacks include a hard inorganic material in place of the cured films 4, as an insulating layer. Conventional stacks thus cannot eliminate warping of the elements or the stacks by stress relaxation and may have cracking of the elements or chips. The stack B of the present invention can eliminate warping of the elements or chips by stress relaxation because it includes the cured film of the curable resin composition of the present invention. The stack B thus can impart high electrical connection reliability to the elements. Moreover, since the cured film of the present invention is less likely to crack due to high temperature even when made thick, the cured film can further reduce warping and cracking of the elements and chips.

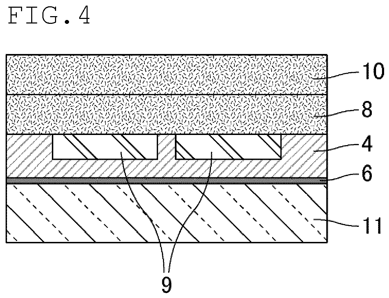

FIG. 4 is a schematic view of an embodiment of the stack of the present invention. The embodiment in FIG. 4 includes, in addition to the components of the embodiment in FIG. 3, an inorganic layer 6 between the cured film 4 and the supporting substrate, providing higher insulation. The inorganic layers 6 may be far thinner than insulating layers of conventional stacks, and thus do not hinder the elimination of warping of the elements or the stack.

Examples of the method for producing the stack B of the present invention include a method of producing a stack, including the steps of: forming a cured film by forming a film of the curable resin composition of the present invention on the first surface of the third element, evaporating the solvent, and then curing the film; and bonding the first surface of the third element, on which the cured film is formed, and the supporting substrate.

With the method for producing the stack B of the present invention, first, the following step is performed: the step of forming a cured film by forming a film of the curable resin composition of the present invention on the first surface of the third element, evaporating the solvent, and then curing the film.

Since even a thick cured film of the curable resin composition of the present invention is less likely to crack due to high temperature, the curable resin composition can reduce warping or cracking of the element and chips, and thus can impart high electrical connection reliability between the elements. The film formation method and conditions are the same as those for the method for producing the stack A.

With the method for producing the stack B of the present invention, subsequently, the step of forming an inorganic layer is performed, as necessary.

The method for forming the inorganic layer is the same as that for the method for producing the stack A.

With the method for producing the stack B of the present invention, subsequently, the step of bonding the first surface of the third element, on which the cured film is formed, and the supporting substrate is performed.

Examples of the method for bonding the third element and the supporting substrate include a method of chemically bonding the surfaces by heat treatment. The heat treatment is typically performed at about 400°C for about four hours.

The stack B of the present invention may be used in any application. Since the stack B has high electrical connection reliability and particularly can reduce warping or cracking of the elements or the stack even when thin elements are bonded to each other, the stack can be suitably used as a stack that constitutes a semiconductor device or an imaging device.

The present invention also encompasses such a semiconductor device including the stack B of the present invention and such an imaging device including the stack of the present invention.

### - Advantageous Effects of Invention

The present invention can provide a curable resin composition capable of forming a film which, even when made thick, is less likely to crack at high temperature under a nitrogen atmosphere, a cured film formed using the curable resin composition, a stack including the cured film, an imaging device including the stack, an semiconductor device including the stack, a method for producing the stack, and a method for producing an element including a bonding electrode for use in production of the stack.

### BRIEF DESCRIPTION OF DRAWINGS

FIG. 1 is a schematic view of an embodiment of the stack of the present invention.
FIG. 2 is a schematic view of an embodiment of the stack of the present invention.
FIG. 3 is a schematic view of an embodiment of the stack of the present invention.
FIG. 4 is a schematic view of an embodiment of the stack of the present invention.

### DESCRIPTION OF EMBODIMENTS

Embodiments of the present invention are more specifically described in the following with reference to examples. The present invention, however, is not limited to these examples.

### (1) Production of main polymer A

A reaction vessel equipped with a reflux condenser, a thermometer, and a dropping funnel was charged with 320 g of phenyltrimethoxysilane (available from Tokyo Chemical Industry Co., Ltd., weight average molecular weight 198.29), 8.8 g of sodium hydroxide, 6.6 g of water, and 263 mL of 2-propanol. Heating was started under a nitrogen gas flow with stirring. Stirring was continued for six hours from the start of reflux, and the mixture was then left to stand overnight at room temperature. The reaction mixture was transferred into a filter and filtered by pressurization with nitrogen gas. The obtained solid was washed with 2-propyl alcohol once, filtered, and then dried at 80°C under reduced pressure to give 330 g of a colorless solid (DD-ONa).

Next, a reaction vessel equipped with a reflux condenser, a thermometer, and a dropping funnel was charged with 20 g of cyclopentyl methyl ether, 2.4 g of 2-propanol, 14 g of ion-exchanged water, and 7.25 g of trichloromethylsilane (available from Tokyo Chemical Industry Co., Ltd., weight average molecular weight 115.03). They were stirred under a nitrogen atmosphere at room temperature. Subsequently, 8 g of the obtained compound (DD-ONa) and 20 g of cyclopentyl methyl ether were put into the dropping funnel, made into a slurry, and added dropwise into the reactor over 30 minutes. Stirring was continued for 30 minutes after the termination of the dropwise addition. After the reaction, stirring was terminated, and the mixture was left to stand to be separated into an organic layer and an aqueous layer. The organic layer was neutralized by washing with water, passed through a membrane filter to remove impurities, and concentrated under reduced pressure at 60°C using a rotary evaporator to give a 9.5 g of a colorless solid. This colorless solid was washed with 10 g of methyl acetate and dried under reduced pressure, whereby 6.2 g of a colorless, powdery solid (DD(Me)-OH) was obtained.

Under a nitrogen atmosphere, the silsesquioxane derivative (DD(Me)-OH) (150 g), octamethylcyclotetrasiloxane (D4) (54.4 g), sulfuric acid (15.2 g), toluene (176 g), and 4-methyltetrahydropyran (43.9 g) were put in a reactor, heated to 100°C, and stirred for five hours. Water was poured to the reaction mixture, and the aqueous layer was extracted with toluene. The combined organic layers were washed with water, a sodium hydrogen carbonate aqueous solution and saturated saline, and then dried with anhydrous sodium sulfate. This solution was concentrated under reduced pressure, and the residue was reprecipitated (2-propanol:ethyl acetate = 50:7, weight ratio) for purification, whereby a compound (formula (13)) (152 g) was obtained. ¹H-NMR and GPC analysis showed that the obtained white solid was a silicon compound having a ratio (α) of siloxane groups to silsesquioxane groups of 4.1 and a weight average molecular weight of 36,000.

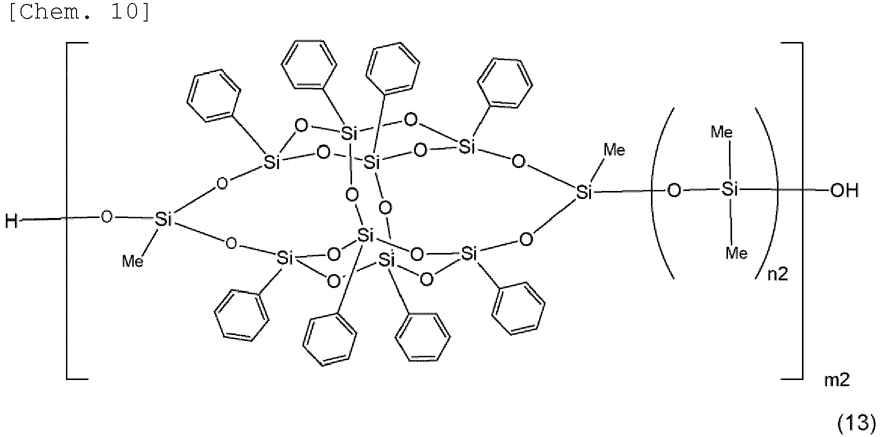

### (2) Main polymer B

### (Details on SR-13)

SR-13 (available from Konishi Chemical Ind Co., Ltd.), a silsesquioxane having a random structure, was used.

### (3) Production of polyimide C-BSI

### (Production method and structure)

A condenser, a mechanical stirrer, a Dean-Stark trap, an oil bath, and a thermometer protecting tube were attached to a 100-mL flask. The flask was charged with 11.1 g of 4,4'-(hexafluoroisopropylidene)diphthalic anhydride (6FDA) (available from Daikin Industries, Ltd.), 7.8 g of bisaminopropyltetramethyldisiloxane (PAM-E, Shin-Etsu Silicone Co., Ltd.), and 92.1 g of anisole, and they were stirred. The flask was heated at 100°C for one hour, followed by reflux in an oil bath at 170°C for one hour. The solution was cooled to room temperature, and 1.22 g of succinic anhydride (available from Tokyo Chemical Industry Co., Ltd.) and 0.32 g of methanesulfonic acid (available from Tokyo Chemical Industry Co., Ltd.) were added. The solution was stirred at 120°C for 10 minutes and then refluxed in an oil bath at 170°C for one hour, whereby a polyimide C-BSI (weight average molecular weight: 9,900) having the structures of the formula (1) at both terminals of the structure of the following formula (14) was obtained.

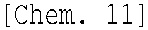

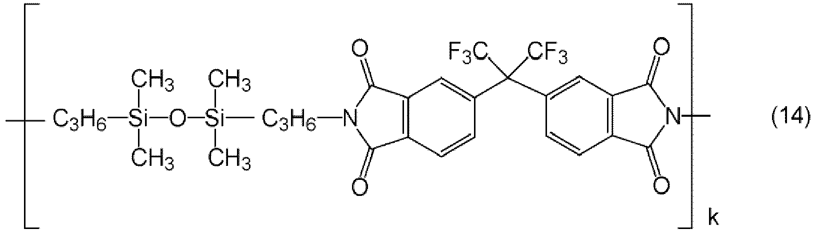

In the formula, k is the number of repeating units.

### (4) Production of polyimide C-CF₃BMI

A condenser, a mechanical stirrer, a Dean-Stark trap, an oil bath, and a thermometer protecting tube were attached to a 100-mL flask. The flask was charged with 11.1 g of 4,4'-(hexafluoroisopropylidene)diphthalic anhydride (available from Daikin Industries, Ltd.), 7.8 g of bisaminopropyltetramethyldisiloxane (PAM-E, Shin-Etsu Chemical Co., Ltd.), and 92.1 g of anisole, and they were stirred. The flask was heated at 100°C for one hour, followed by reflux in an oil bath at 170°C for one hour. The solution was cooled to room temperature, and 2.0 g of trifluoromethylmaleic anhydride (available from Apollo Scientific Ltd.) and 0.2 g of a 0.1 wt% hydroquinone solution in ethanol (available from Tokyo Chemical Industry Co., Ltd.) were added. The solution was stirred at 120°C for 10 minutes and then refluxed in an oil bath at 170°C for one hour, whereby a polyimide C-CF₃BMI (weight average molecular weight: 10,000) having the structures of the formula (2) at both terminals of the structure of the formula (14) was obtained.

### (5) Production of polyimide C-BO

A condenser, a mechanical stirrer, a Dean-Stark trap, an oil bath, and a thermometer protecting tube were attached to a 100-mL flask. The flask was charged with 11.1 g of 4,4'-(hexafluoroisopropylidene)diphthalic anhydride (available from Daikin Industries, Ltd.), 7.8 g of bisaminopropyltetramethyldisiloxane (PAM-E, Shin-Etsu Chemical Co., Ltd.), and 92.1 g of anisole, and they were stirred. The flask was heated at 100°C for one hour, followed by reflux in an oil bath at 170°C for one hour. The solution was cooled to room temperature, and 1.0 g of phenol (available from Tokyo Chemical Industry Co., Ltd.) and 0.6 g of paraformaldehyde (available from Tokyo Chemical Industry Co., Ltd.) were added. The solution was stirred at 110°C for three hours and then left to cool to room temperature with stirring, whereby a polyimide C-BO (weight average molecular weight: 5,600) having the structures of the formula (3) at both terminals of the structure of the formula (14) was obtained. Separately, a polyimide C-BO having a weight average molecular weight of 2,200 was obtained by changing the molar ratio between PAM-E and 6FDA from 1:0.83 to 1:0.50.

### (6) Production of polyimide C-BMI

A polyimide C-BMI (weight average molecular weight: 12,700) having the structures of the formula (4) at both terminals of the structure of the formula (14) was obtained as in Production of polyimide C-CF₃BMI, except that no hydroquinone solution was added, and that 1.2 g of maleic anhydride (available from Tokyo Chemical Industry Co., Ltd.) was used instead of trifluoromethylmaleic anhydride.

### (7) Production of polyimide C-BCI

A polyimide C-BCI (weight average molecular weight: 9,600) having the structures of the formula (5) at both terminals of the structure of the formula (14) was obtained as in Production of polyimide C-BMI, except that 1.3 g of citraconic anhydride (available from Tokyo Chemical Industry Co., Ltd.) was used instead of maleic anhydride. Separately, a polyimide C-BCI having a weight average molecular weight of 25,000 was obtained by changing the molar ratio between PAM-E and 6FDA from 1:0.83 to 1:0.95, and a polyimide C-BCI having a weight average molecular weight of 56,000 was obtained by changing the molar ratio between PAM-E and 6FDA from 1:0.83 to 1:0.97.

### (8) Production of polyimide C-PEPA

A polyimide C-PEPA (weight average molecular weight: 9,900) having the structures of the formula (6) at both terminals of the structure of the formula (14) was obtained as in Production of polyimide C-BMI, except that 3.0 g of 4-phenylethynylphthalic anhydride (available from Tokyo Chemical Industry Co., Ltd.) was used instead of maleic anhydride.

### (9) Production of polyimide D

A polyimide D (weight average molecular weight: 10,000) having the structures of the formula (5) at both terminals of the structure of the following formula (15) was obtained as in Production of polyimide C-BCI, except that a 300-mL recovery flask was used instead of the 100-mL recovery flask, that 37.0 g of DDSQ-01 (available from Japan Material Technologies Corporation) was used instead of 4,4'-(hexafluoroisopropylidene)diphthalic anhydride, and that 235.0 g, instead of 92.1 g, of anisole was used.

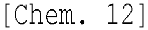

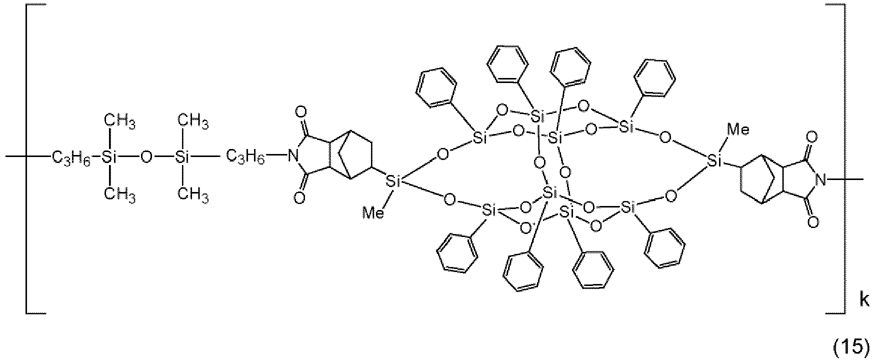

In the formula, k is the number of repeating units.

### (10) Production of polyimide E

A polyimide E (weight average molecular weight: 9,900) having the structures of the formula (5) at both terminals of the structure of the following formula (16) was obtained as in Production of polyimide C-BCI, except that 13.0 g of 4,4'-(4,4'-isopropylidenediphenoxy)diphthalic anhydride (BPADA, available from Tokyo Chemical Industry Co., Ltd.) was used instead of 4,4'-(hexafluoroisopropylidene)diphthalic anhydride, and that 117.7 g of anisole was used.

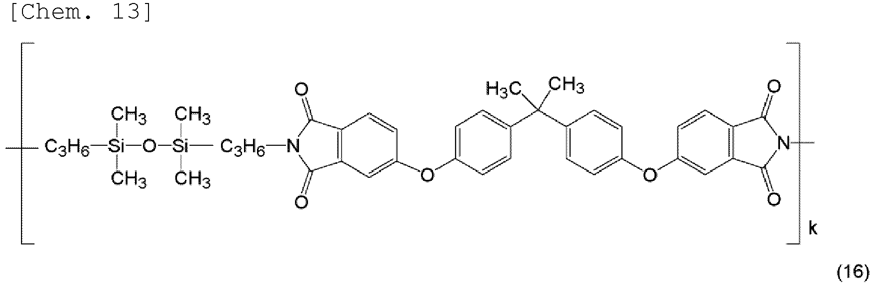

In the formula, k is the number of repeating units.

### (11) Production of polyimide F

A condenser, a mechanical stirrer, a Dean-Stark trap, an oil bath, and a thermometer protecting tube were attached to a 100-mL flask. The flask was charged with 9.9 g of 4,4'-(4,4'-isopropylidenediphenoxy)diphthalic anhydride (BPADA, available from Tokyo Chemical Industry Co., Ltd.), 6.4 g of 2,2'-bis(trifluoromethyl)benzidine (TFDB, available from Tokyo Chemical Industry Co., Ltd.), and 79.6 g of anisole, and they were stirred. The flask was heated at 100°C for one hour, followed by reflux in an oil bath at 170°C for one hour, whereby a polyimide F (weight average molecular weight: 55,000) having NH₂ at both terminals of the structure of the following formula (17) was obtained.

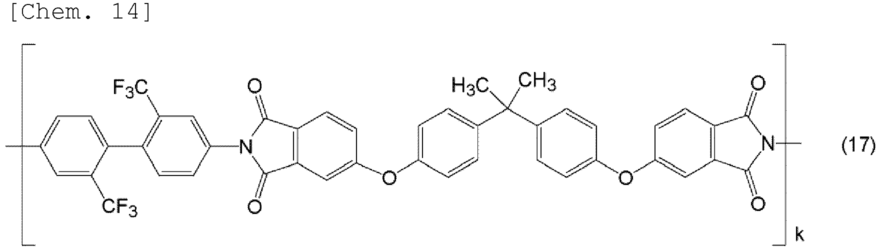

In the formula, k is the number of repeating units.

### (12) Production of polyimide G

A polyimide G (weight average molecular weight: 10,000) having the structures of the formula (5) at both terminals of the structure of the following formula (18) was obtained as in Production of polyimide C-BCI, except that 11.5 g of bis(1,3-dioxo-1,3-dihydroisobenzofuran-5-carboxylic acid) 1,4-phenylene ester (TAHQ, available from Tokyo Chemical Industry Co., Ltd.) was used instead of 4,4'-(hexafluoroisopropylidene)diphthalic anhydride.

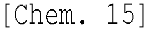

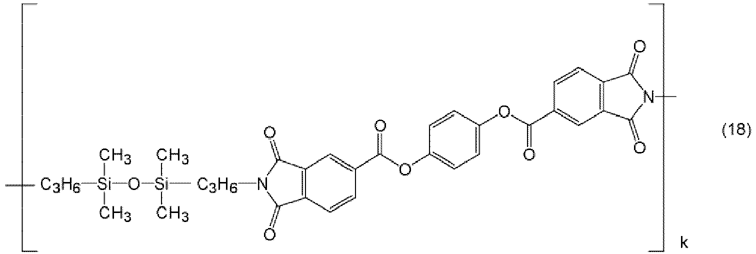

In the formula, k is the number of repeating units.

### (Example 1)

A curable resin composition was obtained by mixing 100 parts by weight of the main polymer A, 3.2 parts by weight of a crosslinking agent (Silicate MS-51, available from Mitsubishi Chemical Corporation), 0.2 parts by weight of a catalyst (ZC-162, available from Matsumoto Fine Chemical Co., Ltd.), 1 part by weight of the polyimide C-BSI, and 67.5 parts by weight of ethyl benzoate as a solvent.

### (Examples 2 to 9 and 11 to 15 and Comparative Examples 1 to 4)

Curable resin compositions were obtained as in Example 1, except that the formulations were as shown in Tables 1 and 2.

### (Example 10)

A curable resin composition was obtained as in Example 1, except that a solvent mixture of anisole and MEK at 1:1 was used as the solvent instead of ethyl benzoate, and that the formulation was as shown in Table 1.

### (Comparative Example 5)

EBECRYL 3605 (available from DAICEL-ALLNEX Ltd.) was used as the main polymer. A curable resin composition was obtained by adding 1 part by weight of PERBUTYL H (available from NOF Corporation) and 1 part by weight of C-BCI having a weight average molecular weight of 9,600 to 100 parts by weight of EBECRYL 3605.

### <Evaluation>

The curable resin compositions obtained in the examples and the comparative examples were evaluated as follows. Tables 1 and 2 show the results.

### (Evaluation of film cracking)

An amount of 15 g of the curable resin composition was ejected onto a center portion of an 8-inch silicon (surface roughness <0.1 µm) and applied to the silicon wafer by spin coating using a spin coater (ACT-400II, available from Active, Ltd.) for 12 seconds at a rotation rate of 500 rpm. The solvent was evaporated in an oven at 125°C for 10 minutes, whereby a 70-um resin film was obtained. The resin film was heat-treated at 300°C for one hour to form a cured film. The obtained cured film was heat-treated for three hours under a nitrogen atmosphere at 400°C using Rapid Thermal Vacuum Process Oven (VPO-650, available from UniTemp), and the film-forming properties were evaluated in accordance with the following criteria.
∘ (Good): No film cracking after heat treatment.
× (Poor): Film cracking occurred after heat treatment.
×× (Very Poor): Film cracking occurred in evaporating the solvent.

### (Evaluation of surface roughening)

A cured film was obtained in the same method as in the evaluation of film cracking. The surface of the cured film was imaged to provide a height distribution image of a randomly selected area (3,000 um × 600 µm) by image stitching using a laser microscope (OLS4100, available from Olympus Corporation). The height difference between the highest point and the lowest point was measured to evaluate the degree of surface roughening. The values in the parentheses in the tables represent the height difference values (pm). In Comparative Examples 2 and 3, the evaluation was not performed because film cracking occurred in evaporating the solvent.
∘ (Good): Height difference of 1 um or less.
× (Poor): Height difference of greater than 1 µm.

### (Evaluation of film cracking in air atmosphere oven at 400°C)

An amount of 15 g of the curable resin composition was ejected onto a center portion of an 8-inch silicon (surface roughness <0.1 µm) and applied to the silicon wafer by spin coating using a spin coater (ACT-400II, available from Active, Ltd.) for 12 seconds at a rotation rate of 500 rpm. The solvent was evaporated in an oven at 125°C for 10 minutes, whereby a 70-µm resin film was obtained. The resin film was further heat-treated at 300°C for one hour to form a cured film. The obtained cured film was heat-treated for three hours under an air atmosphere at 400°C using a muffle furnace (FP413, available from Yamato Scientific Co., Ltd.). The film-forming properties in an air atmosphere oven at 400°C were evaluated in accordance with the following criteria. In Comparative Examples 1 to 5, the evaluation was not performed because the film cracking evaluation results were "×" (Poor) or "××" (Very poor).
∘ (Good): No film cracking after heat treatment.
× (Poor): Film cracking occurred after heat treatment.

**[Table 1]**

| [Table 1A] | | | | | | | | | | |
|---|---|---|---|---|---|---|---|---|---|---|
| | | | Example 1 | Example 2 | Example 3 | Example 4 | Example 5 | Example 6 | Example 7 | |
| Formulation | Main polymer | Type | A | A | A | A | A | A | A | |
| | | Parts (by weight) | 100 | 100 | 100 | 100 | 100 | 100 | 100 | |
| | Polyimide | Type | C-BSI | C-BMI | C-BCI | C-CF₃BMI | C-BO | C-PEPA | D | |
| | | Parts (by weight) | 1 | 1 | 1 | 1 | 1 | 1 | 1 | |
| | | Weight average molecular weight | 9900 | 12700 | 9600 | 10000 | 5600 | 9900 | 10000 | |
| | | C/Si ratio | 15.5 | 15.5 | 15.5 | 15.5 | 15.5 | 15.5 | 6.7 | |
| | Crosslinking agent | Parts (by weight) | 3.2 | 3.2 | 3.2 | 3.2 | 3.2 | 3.2 | 3.2 | |
| | Catalyst | Parts (by weight) | 0.2 | 0.2 | 0.2 | 0.2 | 0.2 | 0.2 | 0.2 | |
| Evaluation | Film cracking | | ○ | ○ | ○ | ○ | ○ | ○ | ○ | |
| | Surface roughening | | ○ (0.7) | O (0.3) | O (0.3) | O (0.1) | O (0.3) | O (0.6) | ○ (0.7) | |
| | Film cracking in air atmosphere oven at 400°C | | × | × | × | × | × | × | × | |

| [Table 1B] | | | | | | | | | | |
|---|---|---|---|---|---|---|---|---|---|---|
| | | | Example 8 | Example 9 | Example 10 | Example 11 | Example 12 | Example 13 | Example 14 | Example 15 |
| Formulation | Main polymer | Type | A | A | A | A | A | A | A | A |
| | | Parts (by weight) | 100 | 100 | 100 | 100 | 100 | 100 | 100 | 100 |
| | Polyimide | Type | C-CF₃BMI | E | F | G | C-NH₂ | C-BCI | C-BCI | C-BO |
| | | Parts (by weight) | 50 | 5 | 20 | 5 | 1 | 1 | 1 | 1 |
| | | Weight average molecular weight | 10000 | 9900 | 55000 | 11000 | 9800 | 56000 | 25000 | 2200 |
| | | C/Si ratio | 15.5 | 21.5 | - | 18 | 15.5 | 15.5 | 15.5 | 15.5 |
| | Crosslinking agent | Parts (by weight) | 3.2 | 3.2 | 10 | 3.2 | 3.2 | 3.2 | 3.2 | 3.2 |
| | Catalyst | Parts (by weight) | 0.2 | 0.2 | 0.1 | 0.2 | 0.2 | 0.2 | 0.2 | 0.2 |
| Evaluation | Film cracking | | ○ | ○ | ○ | ○ | ○ | ○ | ○ | ○ |
| | Surface roughening | | ○ (0.1) | × (2) | × (15) | × (5) | × (10) | × (7) | × (3) | ○ (0.1) |
| | Film cracking in air atmosphere oven at 400°C | | × | ○ | ○ | × | × | × | × | × |

**[Table 2]**

| | | | Comparative Example 1 | Comparative Example 2 | Comparative Example 3 | Comparative Example 4 | Comparative Example 5 |
|---|---|---|---|---|---|---|---|
| Formulation | Main polymer | Type | A | B | A | A | EBECRYL 3605 |
| | | Parts (by weight) | 100 | 100 | 100 | 100 | 100 |
| | Polyimide | Type | - | - | C-BCI | C-CF₃BMI | C-BCI |
| | | Parts (by weight) | - | - | 100 | 0.1 | 1 |
| | | Weight average molecular weight | - | - | 9600 | 10000 | 9600 |
| | | C/Si ratio | - | - | 15.5 | 15.5 | 15.5 |
| | Crosslinking agent | Parts (by weight) | 3.2 | 3.2 | 3.2 | 3.2 | - |
| | Catalyst | Parts (by weight) | 0.2 | 0.2 | 0.2 | 0.2 | - |
| Evaluation | Film cracking | | × | ×× | ×× | × | × |
| | Surface roughening | | ○ (0.2) | - | - | ○ (0.1) | × (3) |
| | Film cracking in air atmosphere oven at 400°C | | - | - | - | - | - |

### INDUSTRIAL APPLICABILITY

The present invention can provide a curable resin composition capable of forming a film which, even when made thick, is less likely to crack at high temperature under a nitrogen atmosphere, a cured film formed using the curable resin composition, a stack including the cured film, an imaging device including the stack, an semiconductor device including the stack, a method for producing the stack, and a method for producing an element including a bonding electrode for use in production of the stack.

### REFERENCE SIGNS LIST

- 1: first element
- 2: second element
- 3: electrode
- 4: cured film
- 5: through-hole
- 6: inorganic layer
- 7: barrier metal layer
- 8: third element
- 9: chip
- 10: fourth element
- 11: supporting substrate

## Claims

1. A curable resin composition comprising:
a polyimide; and
a silsesquioxane,
the polyimide being contained in an amount of 0.5 parts by weight or more and 50 parts by weight or less relative to 100 parts by weight of the silsesquioxane.

2. The curable resin composition according to claim 1,
wherein the polyimide has a siloxane bond.

3. The curable resin composition according to claim 2,
wherein the polyimide has a ratio of carbon atoms to silicon atoms, C/Si, of 17 or less in a main chain structure.

4. The curable resin composition according to any one of claims 1 to 3,
wherein the polyimide has a weight average molecular weight of 1,000 or greater and 20,000 or less.

5. The curable resin composition according to any one of claims 1 to 4,
wherein the polyimide has an oxazine ring or imide ring structure at at least one terminal.

6. The curable resin composition according to any one of claims 1 to 5,
wherein at least one terminal of the polyimide has a structure represented by any of the following formulas (1) to (6):

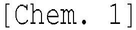

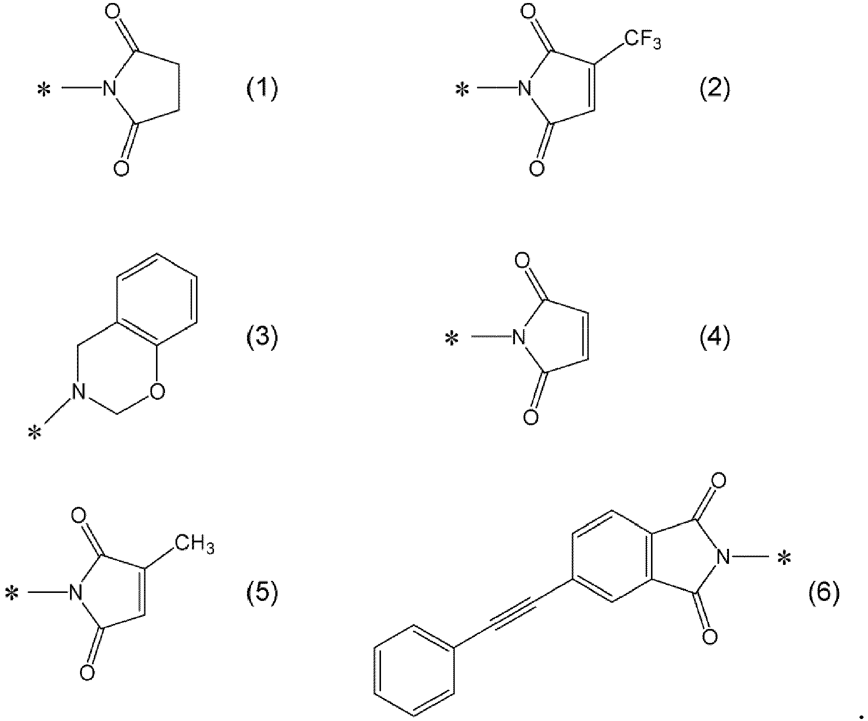

7. The curable resin composition according to any one of claims 1 to 6,
wherein the silsesquioxane has a structure represented by the following formula (7): 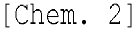 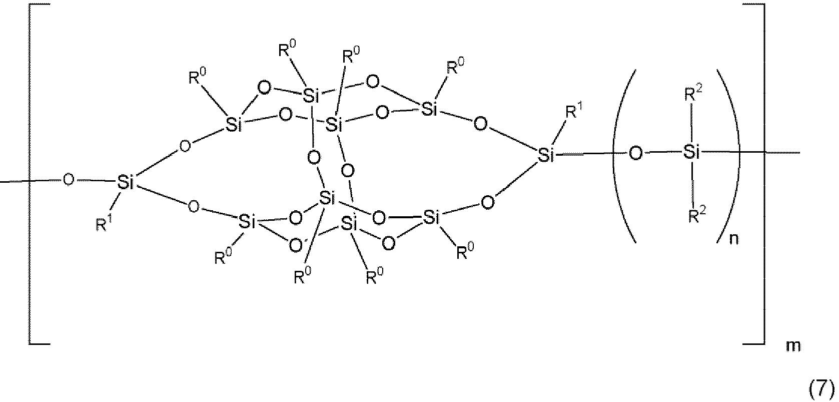
wherein R⁰s, Rs, and Rs each independently represent a linear, branched, or cyclic aliphatic group, an aromatic group, or hydrogen; the aliphatic group and the aromatic group optionally have a substituent; and m and n each represent an integer of 1 or greater.

8. A cured film formed using the curable resin composition according to any one of claims 1 to 7.

9. A stack comprising:
a first element including an electrode;
a second element including an electrode; and
the cured film according to claim 8 between the first element and the second element,
the electrode of the first element and the electrode of the second element being electrically connected to each other via a through-hole extending through the cured film.

10. The stack according to claim 9, comprising an inorganic layer between the first element and the second element.

11. The stack according to claim 9 or 10, comprising a barrier metal layer on a surface of the through-hole.

12. An imaging device comprising the stack according to any one of claims 9 to 11.

13. A semiconductor device comprising the stack according to any one of claims 9 to 11.

14. A method for producing a stack, comprising the steps of:
forming cured films by forming a film of the curable resin composition according to any one of claims 1 to 7 on a surface of a first element including an electrode, the surface being a surface on which the electrode is formed, and a film of the curable resin composition on a surface of a second element including an electrode, the surface being a surface on which the electrode is formed, evaporating the solvent, and then curing the films;
forming a through-hole in each of the cured films;
filling the through-hole with a conductive material;
forming bonding electrodes by polishing the surface of the first element on the side where the through-hole is filled with the conductive material and the surface of the second element on the side where the through-hole is filled with the conductive material; and
bonding the first element on which the bonding electrode is formed and a second element on which the bonding electrode is formed such that the bonding electrodes are bonded to each other.

15. A method for producing an element including a bonding electrode, comprising the steps of:
forming a cured film by forming a film of the curable resin composition according to any one of claims 1 to 7 on a surface of an element including an electrode, the surface being a surface on which the electrode is formed, evaporating the solvent, and then curing the film;
forming a through-hole in the cured film;
filling the through-hole with a conductive material; and
forming a bonding electrode by polishing the surface of the element.

16. A stack comprising:
a supporting substrate;
a third element; and
the cured film according to claim 8 or 9 between the supporting substrate and the third element,
the third element having a first surface and a second surface and including a plurality of chips stacked on the first surface, the chips being electrically connected to the third element,
the cured film being provided between the first surface and the supporting substrate.

17. The stack according to claim 16, comprising an inorganic layer between the supporting substrate and the cured film.

18. The stack according to claim 16 or 17, further comprising a fourth element on the second surface of the third element,
wherein the third element and the fourth element are electrically connected to each other.

19. An imaging device comprising the stack according to any one of claims 16 to 18.

20. A semiconductor device comprising the stack according to any one of claims 16 to 18.
